# EUROPEAN PATENT APPLICATION

(11) **EP 4 761 107 A1**
(43) Date of publication of application: **17.06.2026**
(21) Application number: 25221419.2
(22) Date of filing: 08.12.2025
(51) Int. Cl.: H03F 3/30, H03F 3/45

(54) **SELF-BIASED LOW LEAKAGE UNITY GAIN ANALOG BUFFER**

(30) Priority: 11.12.2024 US 202418976893
(71) Applicant: NXP USA, Inc., Austin, TX 78735 (US)
(72) Inventor: Stockinger, Michael A., 5656AG Eindhoven (NL); Vilas Boas, Andre Luis, 5656AG Eindhoven (NL)
(74) Representative: Schwarzweller, Thomas

(57) **Abstract**

A unity gain buffer including a differential amplifier, detector and feedback circuitry, and an output stage. The differential amplifier receives a difference voltage between a buffer input and output, is coupled to a control node for modulating a current of the differential amplifier, and drives an output node. The detector and feedback circuitry has an input coupled to the buffer input and output and has an output coupled to the control node. The output stage has an input coupled to the output drive node and has an output coupled to the buffer output node. The differential amplifier draws minimal current when the difference voltage is substantially zero and increases current when the difference voltage increases causing the output stage to drive a voltage of the buffer output node back to a voltage of the buffer input node. At least one current booster or a preset load may be added.

## Description

### BACKGROUND

### FIELD

The present disclosure relates in general to buffers, and more particularly to a self-biased, low leakage unity gain analog buffer which may be used for regulating a supply reference for input/output (I/O) cells in a low-power application.

### DESCRIPTION OF THE RELATED ART

In many applications, including, for example, applications in the automotive market, customers want to use their legacy printed-circuit board (PCB) circuits that operate at a higher voltage level with integrated circuits (ICs) manufactured using advanced technology nodes that are optimized for device operation at lower voltage levels. In some applications, for example, customers want to install ICs incorporating transistors that operate only up to a 1.8 Volt (V) nominal voltage, such as implemented using 16 nanometer (nm) FinFET technology, onto legacy PCBs that operate at 3.3V. As a result, the design of higher voltage input/output (I/O) interfaces (e.g., 3.3V) requires at least one additional intermediate voltage domain, usually biased at half of the VDD supply voltage of the I/O domain VDDIO/2, in which the additional voltage domain may be referred to as "IOREF." Within an I/O cell, a stacked configuration is implemented in which a part of the circuit is supplied by IOREF to an internal supply reference voltage VSS, whereas another part is supplied by VDDIO to IOREF.

There are many ways to generate the intermediate voltage domain IOREF from the main voltage domain VDDIO. Since there usually are digital logic loads tied to IOREF, the supply for the intermediate domain must be able to sink and to source current. Most conventional configurations are open-loop schemes, such as, for example, one open-loop individual source-follower for the PMOS side and another one for the NMOS side. The source-follower approach requires two independent voltage references. In many configurations, the separate P and N voltage references are generated elsewhere and distributed across the padring. For limited power budget designs, the voltage reference generators must consume low power and must be able to withstand kickback noise from the switching logic loads. Because of the absence of a feedback loop, the generated references for the N and P sides have been found to vary significantly over process-voltage-temperature (PVT) ranges. Such significant variations can potentially cause safe operating area (SOA) violations as well as degradation of I/O parameters along with reliability concerns.

### BRIEF DESCRIPTION OF THE DRAWINGS

Embodiments of the present invention are illustrated by way of example and are not limited by the accompanying figures. Similar references in the figures may indicate similar elements. Elements in the figures are illustrated for simplicity and clarity and have not necessarily been drawn to scale.
FIG. 1 is a simplified schematic and block diagram of an integrated circuit (IC) mounted on a printed-circuit board (PCB), in which the IC includes multiple input/output (I/O) pads including a unity gain buffer implemented according to one embodiment.
FIG. 2 is a schematic diagram of a unity gain buffer implemented according to one embodiment which may be used as the unity gain buffer of FIG. 1.
FIG. 3 is a series of plots illustrating operation of an embodiment of the buffer of FIG. 2 when configured for a voltage of VDDE at about 3.3V and a voltage of VREF at about 1.65V in response to a direct-current (DC) load current that varies from a large sinking current to a large sourcing current.
FIG. 4 is a set of timing diagrams illustrating operation of an embodiment of the buffer of FIG. 2 in response to a load step transient including a zoomed in timing diagram at a time of the load step.
FIG. 5 is a schematic diagram of a unity gain buffer implemented according to another embodiment including additional current boost response which may also be used as the unity gain buffer of FIG. 1.
FIG. 6 is a series of plots illustrating operation of an embodiment of the buffer of FIG. 5 when configured for a voltage of VDDE at about 3.3V and a voltage of VREF at about 1.65V in response to a DC load current that varies from a large sinking current to a large sourcing current.
FIG. 7 is a set of timing diagrams illustrating operation of an embodiment of the buffer of FIG. 5 in response to a load step transient including a zoomed in timing diagram at a time of the load step.
FIG. 8 is a schematic diagram of I/O pad circuitry including the unity gain buffer of FIG. 1 which may be implemented according to the various embodiments described herein.
FIG. 9 is a schematic and block diagram of a preset load implemented according to one embodiment shown coupled between the output node and the tail node of the unity gain buffer of FIG. 1.

### DETAILED DESCRIPTION

A self-biased unit-gain analog buffer for regulating a lower internal supply reference for I/O cells in a low-power application is described herein. The buffer senses a difference between its input and output and uses a dynamic self-biasing scheme to minimize its power consumption while maintaining the regulation loop. In one embodiment, the unity gain buffer includes a differential transistor pair, a current mirror load coupled to the differential transistor pair, a variable current source transistor primarily developing the tail current of the differential transistor pair, a source follower stage, a pair of detector transistors, and a current mirror detector. The unity gain buffer may further include tail current boost circuitry that uses current sensing transistors inserted in the source follower stage to increase the tail current through the variable current source transistor of the differential transistor pair if the unity gain buffer sources or sinks output current due to an attached load. A preset load may be included, which, when enabled in anticipation of a large load, increases the quiescent tail current of the differential transistor pair to improve the transient response of the unity gain buffer. The preset load may be disabled to minimize power consumption during low power modes.

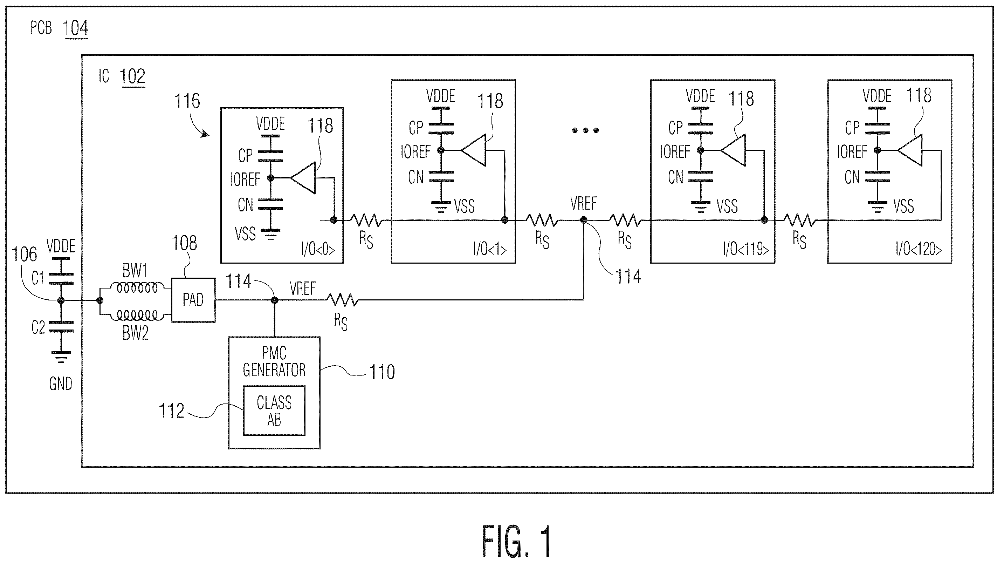

FIG. 1 is a simplified schematic and block diagram of an integrated circuit (IC) 102 mounted on a printed-circuit board (PCB) 104, in which the IC 102 includes multiple input/output (I/O) pads 116 including a unity gain buffer 118 implemented according to one embodiment. The PCB 104 operates using a supply voltage VDDE relative to a supply reference voltage, such as ground (GND), in which VDDE has a voltage level that is greater than the maximum operating voltage of I/O transistors of the IC 102 as further described herein. A first off-chip decoupling capacitor C1 is coupled between VDDE and a node 106 of the IC 102, and a second off-chip decoupling capacitor C2 is coupled between the node 106 and the lower supply voltage VSS. The node 106 is coupled to a pad 108 of the IC 102 through at least one bondwire (shown as a pair of bondwires) BW1 and BW2. The IC 102 includes a power management controller (PMC) generator 110 coupled to the pad 108 for generating a reference voltage VREF on a node 114 coupled to the I/O pads 116. The PMC generator 110 may include a class AB amplifier 112 or the like for regulating VREF at its output to a predetermined voltage level suitable for the devices of the I/O pads 116. The PMC generator 110 may instead include an impedance transformer stage (not shown) or the like for regulating the voltage level of VREF.

The node 114 distributes VREF via a conductor (e.g., conductive traces or the like) within the IC 102, in which the conductor has a characteristic series resistance R_{S}. A series of resistors labeled Rs along the conductor distributing VREF on node 114 are not physical resistors but instead represent the parasitic resistance of the conductor. The I/O pads 116 are individually labeled I/O<0>, I/O<1>, ..., I/O<119>, I/O<120> for a configuration with 121 I/O pads, although any suitable number of I/O pads may be included for different configurations. The pad I/O<0> is shown including a unity gain buffer 118 having an input coupled to the node 114 and having an output providing a voltage IOREF. In this manner, IOREF is intended to have a voltage level that is substantially equal to VREF. An upper decoupling capacitor CP is coupled between VDDE and IOREF, and a lower decoupling capacitor CN is coupled between IOREF and VSS, in which VSS is an on-chip source reference voltage having substantially the same voltage level as GND. Each of the remaining I/O pads 116 (I/O<1> through I/O<120>) may be configured in substantially the same or similar manner depending upon their specific functionality.

Although the series resistance Rs of the conductor carrying VREF on node 114 may be relatively small, any significant load current developed along the conductor flowing through each Rs (or through each segment of the conductive trace) may otherwise cause an undesired voltage change at one or more of the I/O pads 116. The PMC generator 110 only provides local regulation of VREF at its output and does not sense the actual voltage level of VREF at any of the I/O pads 116 for purposes of regulation. For at least this reason, each unity gain buffer 118 within each of the I/O pads 116 has a relatively high input impedance and a relatively low output impedance to prevent significant loading of the node 114.

Each of the I/O pads 116 is shown coupled between VDDE and VSS. It is noted that the IC 102 may have a separate source voltage bus (e.g., VDDIO) that is driven to the same voltage level as VDDE relative to VSS. Generally, VDDE has a voltage level that is greater than the nominal operating voltage of I/O devices within each of the I/O pads 116. The capacitors C1 and C2 collectively operate as a symmetric decoupling capacitor stage that is designed to stabilize the VREF voltage at half of the VDDE voltage (VDDE/2) during switching noise coupled onto the VREF node. The PMC generator 110 regulates VREF at a voltage level at or near VDDE/2, which is distributed to each of the I/O pads 116. Although not shown in FIG. 1, one or more of the I/O pads 116 may be configured in a stacked configuration including one or more transistor devices coupled between VDDIO and IOREF and one or more transistor devices coupled between IOREF and VSS. In this manner, each of the transistor devices in the stacked configuration of the I/O pads 116 receives a voltage at or near VDDE/2. In a more specific configuration, VDDE has a voltage level of about 3.3 Volts (V) and VREF is regulated to a voltage level of about 1.65V, although alternative voltage levels are contemplated.

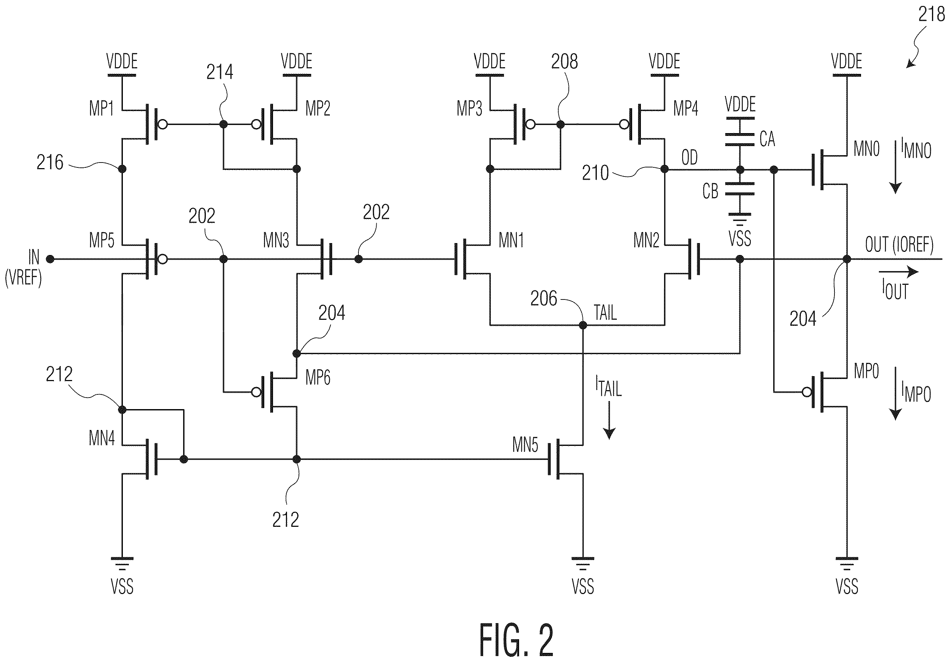

FIG. 2 is a schematic diagram of a unity gain buffer 218 implemented according to one embodiment which may be used as the unity gain buffer 118 of FIG. 1. The buffer 218 includes P-type transistor devices configured as P-channel metal-oxide semiconductor (PMOS) transistors MP0, MP1, MP2, MP3, MP4, MP5, and MP6 and N-type transistor devices configured as N-channel MOS (NMOS) transistors MN0, MN1, MN2, MN3, MN4, and MN5, and a pair of capacitors CA and CB. The buffer 218 is coupled between the upper source voltage VDDE and the lower source voltage VSS and has an input (IN) node 202 and an output node 204 (OUT). When used as any of the buffers 118, the input node 202 is coupled to node 114 biased at VREF, and the output node 204 provides the voltage IOREF which is used as a reference voltage for I/O devices as further described herein. The transistors MP1 - MP6 and MN1 - MN5 may be configured with about the same size, whereas the output transistors MP0 and MN0 may be larger for handling larger output current levels.

MN1 and MN2 are collectively configured as a differential transistor pair each having a source terminal coupled to a TAIL node 206. MN1 has a gate terminal coupled to the input node 202 and a drain terminal coupled to a mirror node 208. MN2 has a gate terminal coupled to the output node 204 and a drain terminal coupled to an output drive (OD) node 210. The differential transistor pair may be viewed as having a pair of inputs and a pair of outputs. The first input of the differential transistor pair is coupled to the input node 202 (input of the buffer 218), the second input is coupled to the output node 204 (output of the buffer 218), the mirror node 208 is a first output node and the OD node 210 is the second output node of the differential transistor pair.

MP3 and MP4 are collectively configured as an output current mirror in which MP3 has a drain terminal and a gate terminal coupled together at the mirror node 208 and MP4 has a gate terminal coupled to the mirror node 208 and a drain terminal coupled to the OD node 210. Each of the source terminals of MP3 and MP4 is coupled to VDDE. Thus, the output current mirror formed by MP3 and MP4 is referenced to the upper supply voltage VDDE having an input coupled to the first output of the differential transistor pair (MN1 and MN2) and having an output coupled to the OD node 210.

MN0 and MP0 are collectively configured as an output stage configured to source current to and sink current from a load coupled to the output node 204. In the illustrated embodiment, the output stage is configured as a source follower stage in which MN0 and MP0 each have a gate terminal coupled to the OD node 210 and a source terminal coupled to the output node 204. MN0, which is configured as a current source transistor of the source-follower stage, has a drain terminal coupled to VDDE. MP0, which is configured as a current sink transistor of the source-follower stage, has a drain terminal coupled to VSS. A current I_{MN0} is shown flowing through MN0 from VDDE to the output node 204, a current I_{MP0} is shown flowing through MP0 from VSS to the output node 204, and an output current I_{OUT} is shown flowing out of the buffer 218 via the output node 204 to a load (not shown).

A first capacitor CA is coupled between VDDE and the OD node 210 and a second capacitor CB is coupled between the OD node 210 and VSS. The capacitors CA and CB are configured to keep the OD node 210 relatively stable in the event of a sudden change in the voltage level of the output node 204. It is noted that the capacitors CA and CB may be implemented using MOS transistor devices. For example, CA may be implemented as a PMOS transistor having its source and drain terminals coupled to VDDE and its gate terminal coupled to the OD node 210, and CB may be implemented as an NMOS transistor having its source and drain terminals coupled to VSS and its gate terminal coupled to the OD node 210. Alternative capacitor configurations are contemplated, such as varactors or metal capacitors or the like. It is noted that when the capacitors CA and CB are implemented using MOS transistor devices, the size of the MOS transistor devices may be sufficiently large, such as having a size similar to that of MN0 and MP0.

MN3 is configured as a first detection transistor device having a gate terminal coupled to the input node 202, a source terminal coupled to the output node 204, and a drain terminal coupled to another mirror node 214. MP6 is configured as a second detection device having a gate terminal coupled to the input node 202, a source terminal coupled to the output node 204, and a drain terminal coupled to a tail current control node 212.

MP1, MP2, and MP5 are collectively configured as a detector current mirror in which MP2 has a drain terminal and a gate terminal coupled together at the mirror node 214 and MP1 has a gate terminal coupled to the mirror node 214 and a drain terminal coupled to a node 216. The source terminals of MP1 and MP2 are both coupled to VDDE. MP5 is configured as a cascade device having a source terminal coupled to node 216, a gate terminal coupled to the input node 202, and a drain terminal coupled to the tail current control node 212.

MN4 and MN5 are collectively configured as a feedback current mirror referenced to VSS having an input coupled to the tail current control node 212 and having an output coupled to the current tail node 206. MN4 has a drain terminal and a gate terminal coupled together at the tail current control node 212 and has a source terminal coupled to VSS. MN5 is configured as a variable current source having a drain terminal coupled to the TAIL node 206, having a source terminal coupled to VSS, and having a gate terminal coupled to the tail current control node 212. A tail current I_{TAIL} flows from the TAIL node 206 through MN5 to VSS.

The differential transistor pair MN1 and MN2, the output current mirror MP3 and MP4, and the variable current source MN5 of the feedback current mirror collectively form one embodiment of a differential amplifier. The differential amplifier is configured to draw minimal current when a difference voltage between the input node 202 (IN) and the output node 204 (OUT) is substantially zero. In some examples, a minimal current may be for example a current of less than 1 uA (microamp) and a substantially zero difference voltage may be a difference voltage of less than 1 mV (millivolt). In the illustrated embodiment, the current of the differential amplifier is essentially the tail current I_{TAIL}. The detection transistors MN3 and MP6 along with the transistors MP1, MP2, MP5, MN4 together with MN5 collectively form detector and feedback circuitry that is configured to increase or otherwise adjust the current of the differential amplifier in response to an increase of the magnitude of the difference voltage. This is typically in the form of an excursion of the voltage of OUT (V_{OUT}) at the output node 204 relative to the voltage of IN (V_{IN}) at the input node 202. The increase of the differential amplifier current in turn causes the output stage (e.g., source follower stage MN0 and MP0) to drive the voltage of OUT back to the voltage level of IN.

Operation of the unity gain buffer 218 is as follows. The buffer 218 presents a high input impedance on the input node 202 to minimize current load on node 114 of the IC 102, and drives the output node 204 to have a voltage level substantially equal to the voltage of the input node 202. The current consumption of the buffer 218 is substantially proportional to the magnitude of the regulation error, which is the voltage difference between voltage OUT on the output node 204 and voltage IN on the input node 202. Otherwise, when the load condition is stable such that the difference voltage is substantially zero, the overall current consumption is very low in which the tail current I_{TAIL} is substantially zero. When the voltage of OUT rises higher than VREF (voltage of IN), MP0 is driven to sink current from the load coupled to the output node 204 to pull the voltage level of OUT back down to the voltage of VREF. When OUT falls below VREF, MN0 is driven to source current to the load to pull the voltage level of OUT back up to VREF.

When the load is such that the buffer 218 sources current to an attached load causing OUT to temporarily drop below IN, the detector MN3 turns on or otherwise draws more current, which is mirrored by the current mirrors MP2, MP1, and MP5 to the current mirror MN4 and MN5 to increase the I_{TAIL} current causing the differential amplifier to operate more strongly (increased current) to drive OUT back up to the voltage level of VREF. When the load is such that the buffer 218 sinks current from the load causing OUT to temporarily rise above VREF, the detector MP6 drives MN5 to increase I_{TAIL} causing the differential amplifier to operate more strongly to reduce the voltage level of OUT back to the voltage level of VREF. In either case, when the buffer 218 returns to a steady state condition (e.g., OUT ≈ IN), the tail current I_{TAIL} is minimal so that the buffer 218 draws very low current.

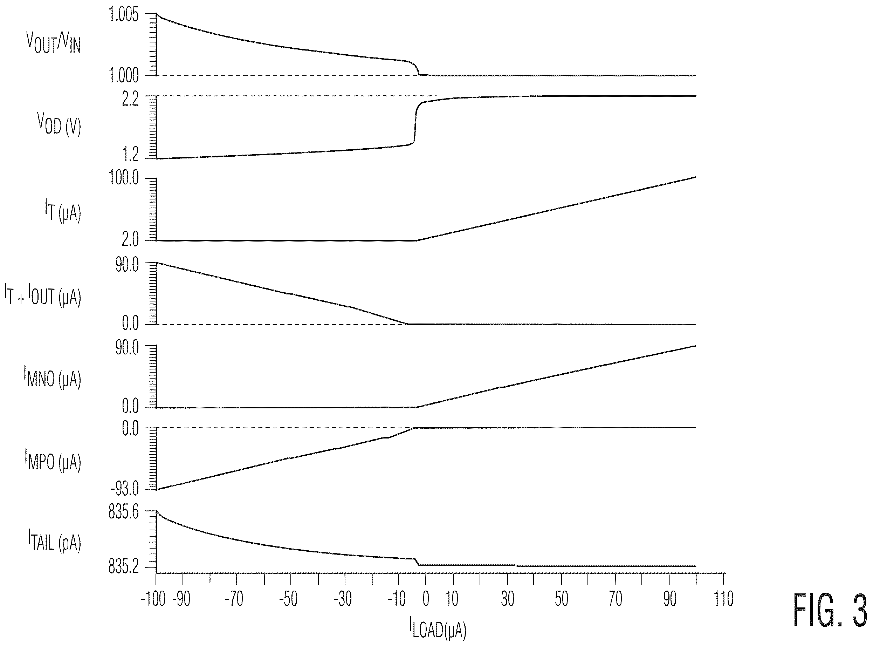

FIG. 3 is a series of plots illustrating operation of an embodiment of the buffer 218 when configured for a voltage of VDDE at about 3.3V and a voltage of VREF at about 1.65V in response to a direct-current (DC) load current that varies from a relatively large sinking current -100 microamperes (µA) to a relatively large sourcing current 100µA. The first plot is a plot of the voltage of OUT (V_{OUT}) divided by the voltage of IN (V_{IN}), in which the ratio of V_{OUT}/V_{IN} stays substantially constant at or near 1.0 over the entire DC load range. The second plot is a plot of the voltage in Volts of OD, or V_{OD}, which slowly rises from about 1.2V during the negative current load and then transitions somewhat quickly to about 2.2V during the positive current load. The third plot is a plot of a total current (I_{T}) in µA flowing from the source voltage VDDE into the buffer 218. I_{T} stays constant at about 2µA during the negative current load and then linearly rises during the positive current load to about 100µA. The fourth plot is a plot of the total current I_{T} plus the output current I_{OUT} in µA, or I_{T} + I_{OUT}, which decreases linearly from over 90µA during the negative current load and stays relative constant at about 0µA during the positive current load. The fifth plot is a plot of the current I_{MN0} in µA flowing through MN0, which stays relatively constant at about 25 (nanoamperes (nA) during the negative current load and then linearly rises to about 90µA during the positive current load when sourcing current. The sixth plot is a plot of the current I_{MP0} flowing through MP0 in µA, which linearly rises from about -93µA during the negative current load when sinking current and then stays relatively constant at about 0µA during the positive current load. The seventh plot is a plot of the tail current I_{TAIL} in picoamperes (pA), which stays relatively constant at about 835pA and varying only by about 0.4pA during the entire DC load range.

A review of the plots of FIG. 3 illustrates that the voltage of OUT relative to VREF and the tail current I_{TAIL} both remain relatively constant over the entire DC load range.

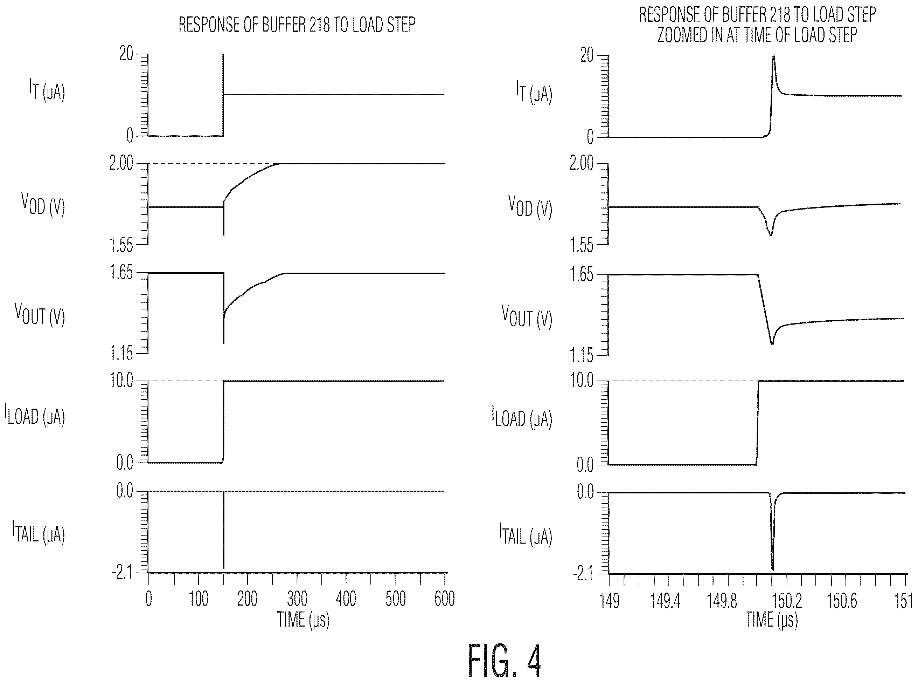

FIG. 4 is a set of timing diagrams illustrating operation of an embodiment of the buffer 218 in response to a load step transient, in which each timing diagram plots a selected parameter of the buffer 218 versus time in microseconds (µs). Again, the buffer 218 is configured for a voltage of VDDE at about 3.3V and a voltage of VREF at about 1.65V. In this case, the load transient steps from 0µA to 10µA at 150 µs. The set of timing diagrams plot I_{T}, V_{OD}, V_{OUT}, I_{LOAD} (which is about the same as I_{OUT}), and I_{TAIL} versus time in which the voltages are plotted in volts (V) and the currents are plotted in µA. The set of timing diagrams includes a first series of timing diagrams on the left with time ranging from 0µs to 600µs, and a second series of timing diagrams on the right zoomed in around the load step time of 150 µs (149µs to 151µs) to more clearly illustrate the step response.

The load step illustrated by I_{LOAD} at 150µs causes the output voltage V_{OUT} to drop from about 1.65V to about 1.2V and ultimately recover after more than 100µs. The magnitude of the tail current suddenly increases by about 1.8µA but appears to rebound back relatively quickly to about the original level. With reference back to FIG. 2, in response to the load transient, the gate-to-source voltage (VGS) of the detection device MN3 increases forcing more current to flow through MP2, which is mirrored by MP1 and MN4 back through MN5 to temporarily increase the tail current and to facilitate a faster adjustment of the output voltage back to its original level. Because the buffer 218 operates with relatively low bias current, however, the transient response is relatively slow, especially at slow manufacturing process corners and at low temperature. In this manner, the buffer 218 is less than optimal for configurations with fast load transients.

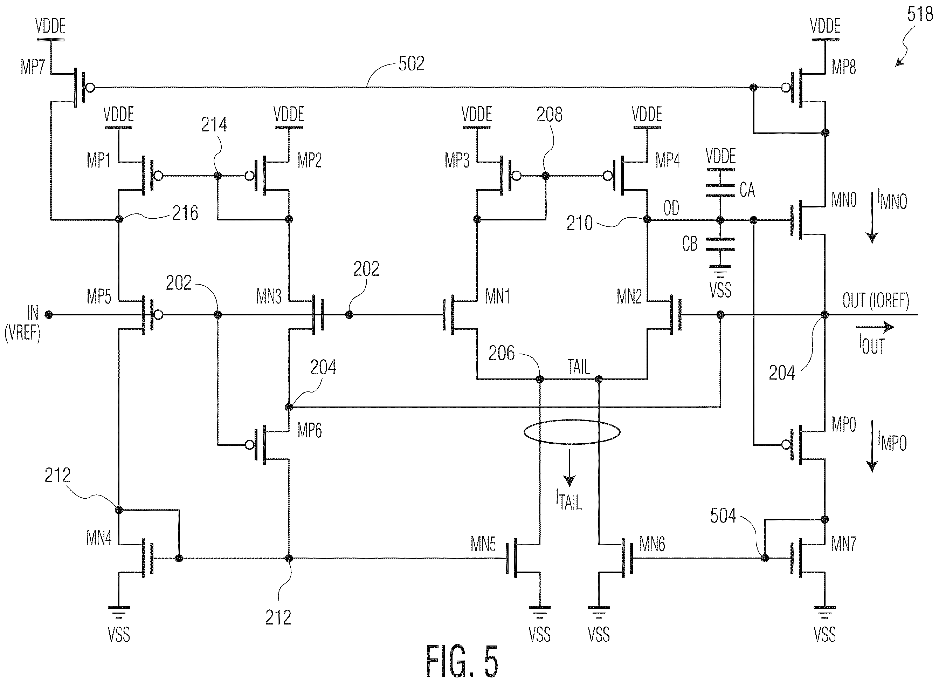

FIG. 5 is a schematic diagram of a unity gain buffer 518 implemented according to another embodiment including additional current boost response, in which the buffer 518 may also be used as the unity gain buffer 118 of FIG. 1. The buffer 518 is configured in substantially similar manner and also includes the PMOS transistors MP0 - MP6, the NMOS transistors MN0 - MN5, and the capacitors CA and CB coupled in substantially similar manner as the buffer 218 coupled between VDDE and VSS and having an input (IN) node 202 and an output (OUT) node 204. The buffer 518 includes additional PMOS transistors MP7 and MP8 and additional NMOS transistors MN6 and MN7. The drain terminal of MN0 is not coupled directly to VDDE but is instead coupled to a source node 502. MP8 has its gate and drain terminals coupled together at the source node 502 and has its source terminal coupled to VDDE. MP7 has a source terminal coupled to VDDE, a gate terminal coupled to the source node 502, and a drain terminal coupled to node 216. The drain terminal of MP0 is not directly coupled to VSS but is instead coupled to a sink node 504. MN7 has its gate and drain terminals coupled together at the sink node 504 and has its source terminal coupled to VSS. MN6 has a drain terminal coupled to the TAIL node 206, a gate terminal coupled to the sink node 504, and a source terminal coupled to VSS. The buffer 518 also has a tail current I_{TAIL} flowing from the TAIL node 206, but the tail current I_{TAIL} for the buffer 518 is the combined current flowing into the drain terminals of both MN5 and MN6.

The additional current mirrors formed by the MP7 and MP8 pair and by the MN6 and MN7 pair form source and sink tail current boosters, respectively, that are each configured to sense output current and to mirror a fraction of this current back into the tail current I_{TAIL} to more quickly respond to fast load transients. When the output voltage V_{OUT} decreases and the output current Iₒᵤₜ increases due to a sudden load change, the I_{MN0} current is mirrored back and injected into node 216 and mirrored by the MN4 and MN5 current mirror to increase the tail current I_{TAIL} through MN5. This increase of the tail current I_{TAIL} through MN5 enables the differential pair MN1 and MN2 to respond more quickly to increase the output voltage V_{OUT} back to its nominal level. Similarly, when V_{OUT} increases and the output current Iₒᵤₜ decreases due to a sudden load change, the I_{MP0} current is mirrored back by the MN6 and MN7 current mirror to increase the tail current I_{TAIL} through MN6. This increase of the tail current I_{TAIL} through MN6 enables the differential pair MN1 and MN2 to respond more quickly to decrease the voltage of OUT back to its nominal level.

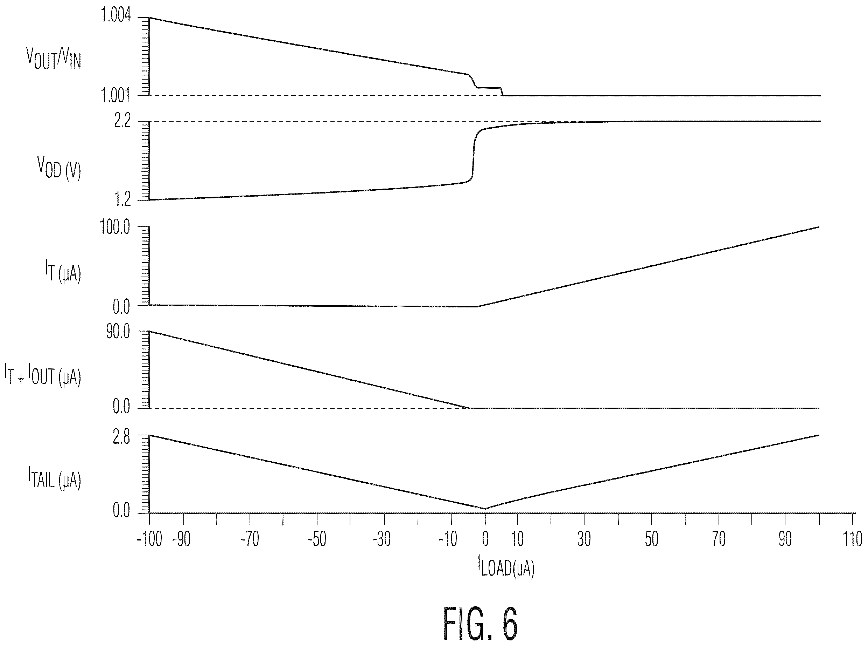

FIG. 6 is a series of plots illustrating operation of an embodiment of the buffer 518 when configured for a voltage of VDDE at about 3.3V and a voltage of VREF at about 1.65V in response to a DC load current that varies from a large sinking current -100µA to a large sourcing current 100µA. The first plot is a plot of the output voltage V_{OUT} divided by the input voltage V_{IN}, in which the ratio of V_{OUT}/V_{IN} stays substantially constant at about 1.0 over the entire DC load range. The second plot is a plot of the voltage of OD, or V_{OD}, which slowly rises from about 1.2V during the negative current load and then transitions somewhat quickly to about 2.2V during the positive current load. The third plot is a plot of a total current I_{T} in µA flowing from the source voltage VDDE into the buffer 518, which stays constant at about 0µA during the negative current load and then linearly rises during the positive current load to about 100µA. The fourth plot is a plot of the total current I_{T} plus the output current I_{OUT}, or I_{T} + I_{OUT}, which decreases linearly from over 90µA during the negative current load and stays relative constant at about 10µA during the positive current load.

The fifth plot is a plot of the tail current I_{TAIL} in µA rather than pA. In contrast to the tail current I_{TAIL} of the buffer 218, the tail current I_{TAIL} of the buffer 518 is larger, ranging up to about 2.8µA during higher load conditions. During the negative current load, the tail current I_{TAIL} of the buffer 518 linearly decreases from about 2.8µA down to almost zero (at low or no load), and then linearly increases back up to about 2.8µA as the positive current load increases. Thus, the buffer 218 draws less tail current overall, but is less responsive to fast output load transients. The buffer 518 draws a greater amount of tail current overall but is more responsive to fast output load transients as further described herein. Both of the buffers 218 and 518 draw very little current during stable, no-load conditions.

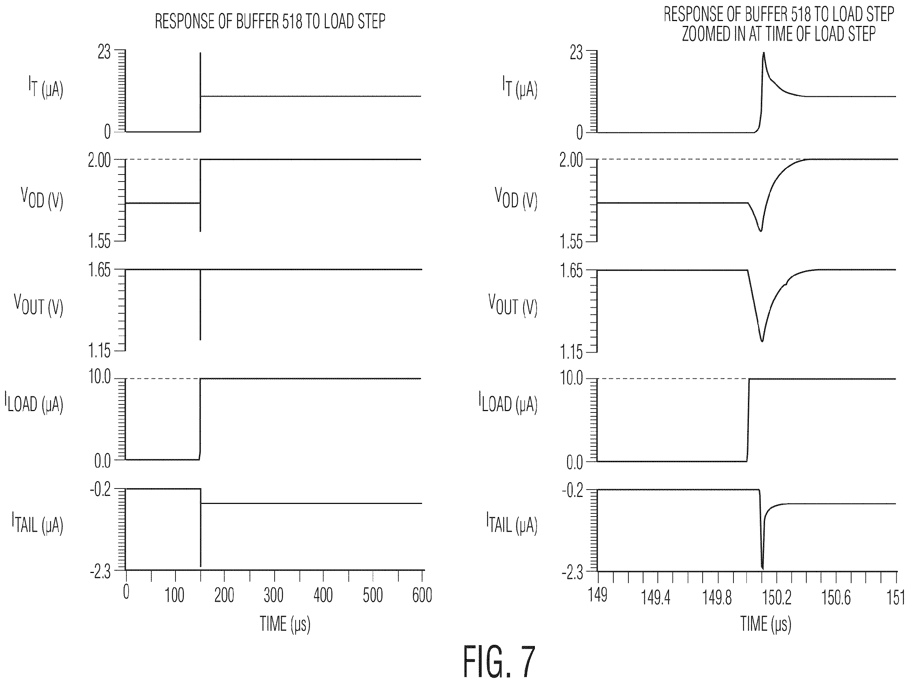

FIG. 7 is a set of timing diagrams illustrating operation of an embodiment of the buffer 518 in response to a load step transient, in which each timing diagram plots a selected parameter of the buffer 518 versus time in microseconds (µs). Again, the buffer 518 is configured for a voltage of VDDE at about 3.3V and a voltage of VREF at about 1.65V. In this case, the load transient steps from 0µA to 10µA at 150 µs. The set of timing diagrams plot I_{T}, V_{OD}, V_{OUT}, I_{LOAD} (which is about the same as I_{OUT}), and I_{TAIL} versus time in which the voltages are plotted in volts (V) and the currents are plotted in µA. The set of timing diagrams includes a first series of timing diagrams on the left with time ranging from 0µs to 600µs, and a second series of timing diagrams on the right zoomed in around the load step time of 150 µs (149µs to 151µs) to more clearly illustrate the step response.

The timing diagrams shown in FIG. 7 are substantially similar to those shown in FIG. 4, except illustrating the response of the buffer 518 rather than the buffer 218. Again, the load step illustrated by I_{LOAD} at 150µs causes the output voltage VOUT to drop from about 1.65V to about 1.2V, but the buffer 518 responds much more quickly and recovers within less than 500ns. Operation of the primary devices of the buffer 518 are similar to that previously described for the buffer 218. In this case, however, the addition of the devices MP7 and MP8 enables much faster response so that the voltage of OUT recovers far more quickly.

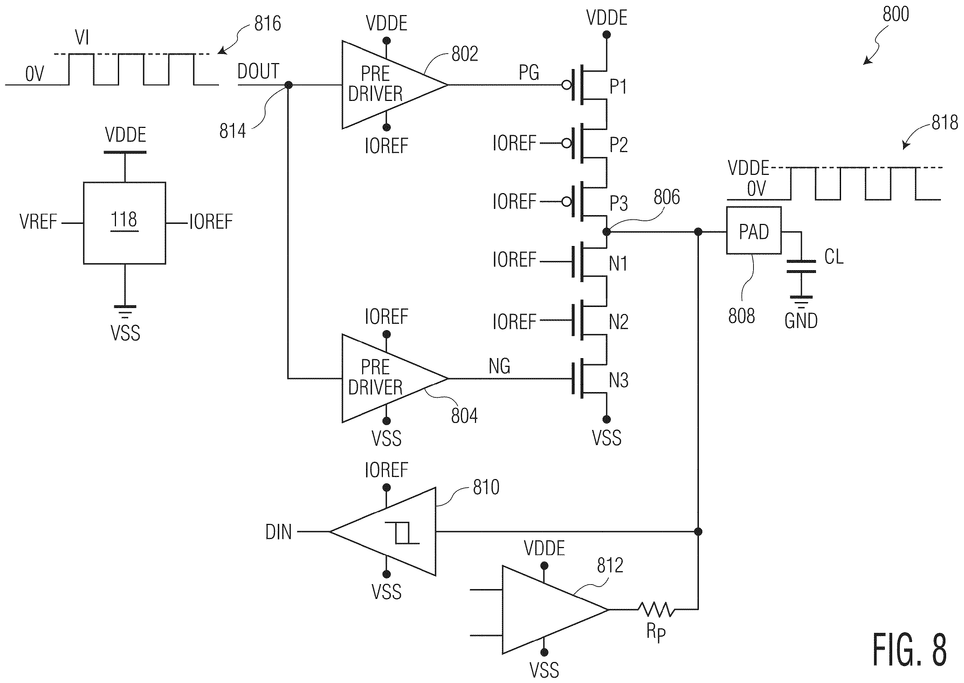

FIG. 8 is a schematic diagram of I/O pad circuitry 800 including the unity gain buffer 118 which may be implemented according to the various embodiments described herein. The buffer 118 may be configured according to the buffer 218 or the buffer 518 in different embodiments, in which it has supply voltage inputs coupled between VDDE and VSS, an input receiving the VREF reference voltage and an output providing an output drive signal IOREF as previously described. The I/O pad circuitry 800 further includes an upper pre-driver 802, a lower pre-driver 804, a cascaded set of PMOS driver devices P1, P2, and P3 coupled between VDDE and an output node 806, a cascaded set of NMOS driver devices N1, N2, and N3 coupled between the output node 806 and VSS, an input buffer 810, and a weak pull-up/weak pull-down (PUPD) driver 812. The output node 806 is coupled to an external PAD 808 and a load capacitor C_{L} is coupled between the PAD 808 and GND.

The pre driver 802 has an input coupled to a data output (DOUT) node 814 and an output providing an upper P-gate drive signal PG to a gate terminal of P1. The pre driver 802 has supply voltage terminals coupled between VDDE and IOREF. The pre driver 804 has an input coupled to the node 814 and an output providing a lower N-gate drive signal PN to a gate terminal of N3. The pre driver 804 has supply voltage terminals coupled between IOREF and VSS. For the cascaded configuration, P1 has a source terminal coupled to VDDE and a drain terminal coupled to a source terminal of P2, which has a drain terminal coupled to a source terminal of P3, which as a drain terminal coupled to the output node 806. N1 has a drain terminal coupled to the output node 806 and a source terminal coupled to a drain terminal of N2, which has a source terminal coupled to a drain terminal of N3, which as a source terminal coupled to VSS. The gate terminals of P2, P3, N1, and N2 are coupled to receive IOREF. The input buffer 810 has an input coupled to the output node 806, an output providing an input signal DIN, and supply voltage terminals coupled between IOREF and VSS. The PUPD driver 812 has an output coupled to the output node 806 through a pull-up/pull-down resistor R_{P}, and has supply voltage terminals coupled between VDDE and VSS. The PUPD driver 812 is internally controlled to provide weak pull-up and weak pull-down functionality during an input mode and is not further described.

In output mode operation of I/O pad circuitry 800, signals internally provided to node 814 are driven by the pre drivers 802 and 804 and the cascaded devices P1-P3 and N1-N3 to the external PAD 808. A signal received by the PAD 808 during the input mode operation of I/O pad circuitry 800 is internally driven as DIN by the input driver 810. It is appreciated that the buffer 118 is used to provide IOREF as a power supply net for both of the pre drivers 802 and 804 and the cascaded devices during the output mode, and for the driver 810 during the input mode.

Simulations have been performed using the illustrated I/O pad circuitry 800 in an output mode of operation using the unity gain buffer 118 configured as the buffer 218 and the buffer 518. In particular, an internal clock signal 816 toggling between 0V (or VSS) and an internal voltage level VI was provided to node 814, which was driven as an output clock signal 818 on the PAD 808 toggling between 0V (or GND) and VDDE. VDDE was about 3.3V, VI was about 1V (e.g., 800mV), and the frequency of the clock signal 816 was around 25 megahertz (MHz). The output clock signal 818 at the PAD 808 is capacitively coupled back into the IOREF via the Drain-to-Gate and Source-to-Gate capacitances of the driver devices P2/P3 and N1/N2. Since IOREF is used as a supply node for the pre-drivers 802 and 804, additional transient load changes occur. Simulation results have shown that this can cause the average voltage level of IOREF to drift. The corresponding voltage drop at the IOREF output may be significant and may cause SOA (Safe Operating Area) violations when the IOREF voltage falls below about 80% of its nominal value. In many I/O applications, therefore, because of the load characteristics seen by the buffer 118, even the current boost provided when configured as the buffer 518 may be insufficient to suppress the possible voltage drift caused by sudden load transients.

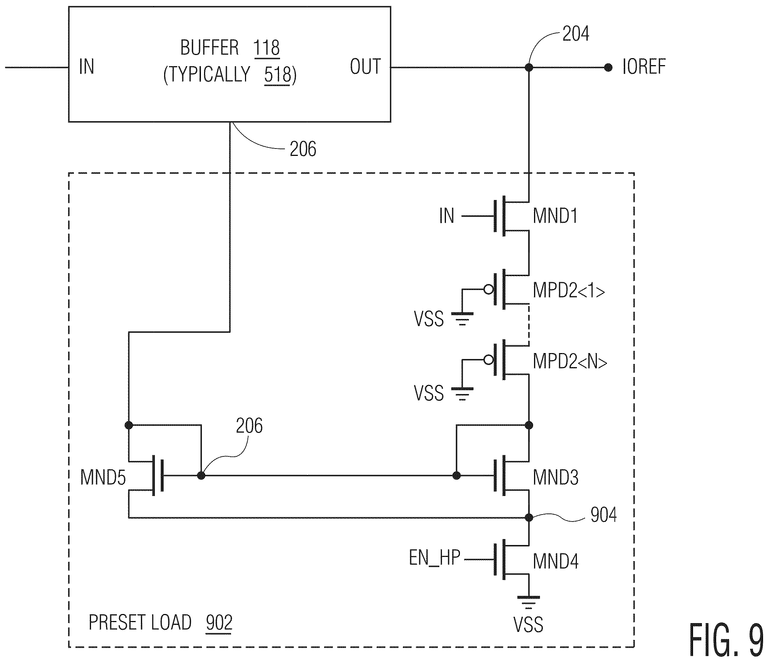

FIG. 9 is a schematic and block diagram of a preset load 902 implemented according to one embodiment shown coupled between the output node 204 and the tail node 206 of the unity gain buffer 118. The preset load 902 may be provided to precondition the buffer 118 for a high-power (HP) mode of operation during which a fast buffer response to transient load changes is desired to keep the IOREF voltage stable. Although the buffer 118 coupled to the preset load 902 may be configured according to the buffer 218, it is typically configured according to the buffer 518 in most configurations to achieve an even faster buffer response during transient load changes due to the described boost effect. The preset load 902 includes a set of cascaded transistor devices including NMOS transistors MND1, MND3, and MND4 and a series of N PMOS transistors MPD2<1>, ..., MPD2<N> and another NMOS transistor MND5. An enable signal EN_HP is asserted "high" to activate the preset load 902 when the buffer 118 is in the HP mode of operation as further described herein. When not in the HP mode of operation, for example when the I/O pad operates in a standby (low-power) mode, EN_HP remains at "low," which deactivates the preset load 902 so that the unity gain buffer 118 operates in a normal mode as previously described.

MND1 has a drain terminal coupled to the output node 204, a gate terminal coupled to the input node 202 (such as for receiving VREF), and a source terminal coupled to a source terminal of MPD2<1>. MPD2<1> is a first of a series of N cascaded PMOS transistors MPD2<1> to MPD2<N>, in which N is at least one (including, therefore, one embodiment with a single cascaded PMOS transistor), each having a pair of current terminals (e.g., source and drain terminals) coupled in series between the source terminal of MND1 and the TAIL node 206. Each of the cascaded PMOS transistors MPD2<1> to MPD2<N> has a gate terminal coupled to VSS. MND3 has a drain terminal and a gate terminal coupled together at the tail node 206, and has a source terminal coupled to an enable node 904. MND4 has a drain terminal coupled to node 904, a source terminal coupled to VSS, and a gate terminal receiving the high power enable signal EN_HP. MND5 has a drain terminal and a gate terminal coupled together at the tail node 206, and has a source terminal coupled to node 904.

Referring back to FIGs 3 and 6, the voltage of the OD node 210 exhibits a significant "deadzone" between positive and negative DC loads. During no load or most DC load conditions, the voltage V_{OD} of the OD node 210 may settle at a voltage level within the deadzone that may not be optimal for the onset of a large load. If a large transient load is suddenly added, such as a fast clock signal, the voltage of the OD node 210 may have to change by a significant amount in response to the sudden onset of the large load. The preset load 902 alleviates this condition by preconditioning the OD node 210 to an optimal level to minimize change during onset of the large load. When enabled by asserting EN_HP before and in anticipation of activation of a large load, the preset load 902 increases the tail current of the buffer 118 during the HP mode of operation. When enabled, the preset load 902 configures the buffer 118 to enable a faster load transient response to more quickly respond to load transients when the difference between the DC load and effective switching load is a large factor, such as, for example, around 2X to 3X or more. The output drop recovery time is much faster. In one embodiment, the preset load 902 enables voltage ripple on IOREF to stay within +/-5%.

Note that the HP mode of operation is only enabled by asserting EN_HP in anticipation of high load conditions, for example when the I/O pad is in "run" mode, particularly application of a large AC load. The HP mode is disabled by negating EN_HP when in a standby mode in which ultra-low power consumption is achieved as may be required for certain configurations.

Aspects of the disclosure are defined in the accompanying claims. In a first aspect, there is provided a unity gain buffer, comprising: a buffer input node and a buffer output node developing a difference voltage; a differential amplifier having a differential input coupled to receive the difference voltage, having a control input coupled to a control node for modulating current of the differential amplifier, and having an output coupled to an output drive node; detector and feedback circuitry having a first input coupled to the buffer input node, having a second input coupled to the buffer output node, and having an output coupled to the control node; and an output stage having an input coupled to the output drive node and having an output coupled to the buffer output node; wherein the differential amplifier is configured to draw minimal current when the difference voltage is substantially zero and wherein the detector and feedback circuitry is configured to increase the current of the differential amplifier in response to an increase of a magnitude of the difference voltage causing the output stage to drive a voltage of the buffer output node towards a voltage of the buffer input node.

In some embodiments, the unity gain buffer may comprise a current booster configured to sense source current through the output stage and to correspondingly adjust the current of the differential amplifier.

In some embodiments, the differential amplifier may comprise: a differential transistor pair having a current tail node, having a first input coupled to the buffer input node, having a second input coupled to the buffer output node, having a first output, and having a second output coupled to output drive node; an output current mirror referenced to a supply voltage, having an input coupled to the first output of the differential transistor pair and having an output coupled to the output drive node; and a variable current source coupled between the current tail node and a supply reference voltage and having a control terminal coupled to the control node, wherein the variable current source is configured to develop a tail current between the current tail node and the supply reference voltage; and wherein the output stage comprises a source follower stage, which comprises: a current source transistor having current terminals coupled between a source node and the buffer output node and having a control terminal coupled to the output drive node; and a current sink transistor having current terminals coupled between the buffer output node and a sink node and having a control terminal coupled to the output drive node.

In some embodiments, the unity gain buffer may further comprise: a source current booster, comprising: a first input transistor having current terminals coupled between the supply voltage and the source node and having a control terminal coupled to the source node; and a first output transistor having current terminals coupled between the supply voltage and the detector and feedback circuitry and having a control terminal coupled to the source node; wherein the source current booster is configured to sense source current through the current source transistor and to correspondingly adjust the tail current through the variable current source.

In some embodiments, the unity gain buffer may further comprise: a sink current booster, comprising: a second input transistor having current terminals interposed between the second supply voltage and the first current terminal of the current sink transistor and having a control terminal coupled to the first current terminal of the current sink transistor; and a second output transistor having current terminals coupled between the current tail node and the supply reference voltage and having a control terminal coupled to the sink node; wherein the sink current booster is configured to mirror sink current through the current sink transistor to an additional tail current between the current tail node and the supply reference voltage.

In some embodiments, the unity gain buffer may further comprise: a preset load coupled to the buffer output node and the differential amplifier and having an enable input; and wherein the preset load is configured to adjust the current of the differential amplifier to enable faster load transient response of the unity gain buffer when the preset load is enabled.

In some embodiments, the unity gain buffer may further comprise: a preset load, comprising: a plurality of cascaded transistors and an enable transistor each having current terminals coupled in series between the buffer output node and the supply reference voltage; and a current transistor having current terminals coupled between a current node of the differential amplifier and the supply reference voltage and coupled in a mirrored configuration with a selected one of the plurality of cascaded transistors; wherein when the enable transistor is enabled, the preset load is configured to adjust the current of the differential amplifier to enable faster load transient response of the unity gain buffer.

In some embodiments, the unity gain buffer may further comprise a first capacitive device coupled between a supply voltage and the output drive node and comprising a second capacitive device coupled between the output drive node and a supply reference voltage.

In some embodiments, the differential amplifier may comprise: a differential transistor pair comprising: a first transistor of a first conductivity type having current terminals coupled between a first node and a current tail node and having a control terminal coupled to the buffer input node; and a second transistor of the first conductivity type having current terminals coupled between the output drive node and the current tail node and having a control terminal coupled to the buffer output node; an output current mirror comprising: a first transistor of a second conductivity type having a first current terminal coupled to the supply voltage, and having a second current terminal and a control terminal coupled to the first node; and a second transistor of the second conductivity type having current terminals coupled between the supply voltage and the output drive node and having a control terminal coupled to the first node; and a variable current source coupled between the current tail node and the supply reference voltage and having a control terminal coupled to the control node.

In some embodiments, the output stage comprises: a current source transistor of the first conductivity type having current terminals coupled between the supply voltage and the buffer output node and having a control terminal coupled to the output drive node; and a current sink transistor of the second conductivity type having current terminals coupled between the buffer output node and the supply reference voltage and having a control terminal coupled to the output drive node.

In some embodiments, the detector and feedback circuitry comprises: a first detector transistor of the second conductivity type having current terminals coupled between the buffer output node and the tail current control node and having a control terminal coupled to the buffer input node, and a second detector transistor of the first conductivity type having current terminals coupled between a mirror node and the buffer output node and having a control terminal coupled to the buffer input node; a detector current mirror referenced to the supply voltage having an input coupled to the mirror node and having an output coupled to the tail current control node; and a feedback current mirror including the variable current source and referenced to the supply reference voltage having an input coupled to the tail current control node and having an output coupled to the current tail node.

In some embodiments, the detector current mirror comprises: a third transistor of the second conductivity type having a first current terminal coupled to the supply voltage and having a second current terminal and a control terminal coupled to the mirror node; a fourth transistor of the second conductivity type having current terminals coupled between the supply voltage and a first node and having a control terminal coupled to the mirror node; and a fifth transistor of the second conductivity type having current terminals coupled between the first node and the tail current control node and having a control terminal coupled to the buffer input node.

In some embodiments, the feedback current mirror comprises: a third transistor of the first conductivity type having a first current terminal coupled to the supply reference voltage and having a second current terminal and a control terminal coupled to the control node; and the variable current source comprising a fourth transistor of the first conductivity type having current terminals coupled between the current tail node and the supply reference voltage and having a control terminal coupled to the control node.

In a second aspect, there is provided an integrated circuit, comprising: an input reference node that develops a reference voltage relative to first and second supply voltages; and an input/output (I/O) pad, comprising: a unity gain buffer, comprising: a buffer input node coupled to the input reference node and a buffer output node coupled to an I/O reference node, wherein the buffer input and output nodes develop a difference voltage; a differential amplifier having a differential input coupled to receive the difference voltage, having a control input coupled to a control node for modulating current of the differential amplifier, and having an output coupled to an output drive node; detector and feedback circuitry having a first input coupled to the input reference node, having a second input coupled to the I/O reference node, and having an output coupled to the control node; and an output stage having an input coupled to the output drive node and having an output coupled to the I/O reference node; wherein the differential amplifier is configured to draw minimal current when the difference voltage is substantially zero and wherein the detector and feedback circuitry is configured to increase the current of the differential amplifier in response to an increase of a magnitude of the difference voltage causing the output stage to drive a voltage of the I/O reference node towards a voltage of the input reference node.

In some embodiments, the I/O pad further comprises: a first pre driver having an input terminal coupled to a data output node, having an output coupled to a first gate node, having a first supply input coupled to the first supply voltage, and having a second supply input coupled to the I/O reference node; a second pre driver having an input terminal coupled to the data output node, having an output coupled to a second gate node, having a first supply input coupled to the I/O reference node, and having a second supply input coupled to the second supply voltage; a first plurality of cascaded driver devices coupled in series, each having current terminals coupled between the first supply voltage and an I/O pad output node and each having a control terminal coupled to the I/O reference node except a first driver device of the first plurality of cascaded driver devices which has a control terminal coupled to the first gate node; and a second plurality of cascaded driver devices coupled in series, each having current terminals coupled between the second supply voltage and the I/O pad output node and each having a control terminal coupled to the I/O reference node except a first driver device of the second plurality of cascaded driver devices which has a control terminal coupled to the second gate node.

In some embodiments, the integrated circuit further comprises at least one additional pad buffer having a first supply input coupled to the I/O reference node and having a second supply input coupled to the second supply voltage.

In some embodiments, the integrated circuit further comprises a current booster configured to sense source current through the output stage and to correspondingly adjust the current of the differential amplifier.

In some embodiments, the output stage of the unity gain buffer comprises a current source transistor and a current sink transistor, wherein the current source transistor has a first current terminal and has a second current terminal coupled to the I/O reference node, and wherein the current sink transistor has a first current terminal and has a second current terminal coupled to the I/O reference node, wherein the unity gain buffer further comprises: a source current booster, comprising: a first input transistor having current terminals interposed between the first supply voltage and the first current terminal of the current source transistor and having a control terminal coupled to the first current terminal of the current source transistor; and a first output transistor having current terminals coupled between the first supply voltage and the detector and feedback circuitry and having a control terminal coupled to the control terminal of the first input transistor; wherein the source current booster is configured to sense source current through the current source transistor to adjust the current of the differential amplifier; and a sink current booster, comprising: a second input transistor having current terminals interposed between the second supply voltage and the first current terminal of the current sink transistor and having a control terminal coupled to the first current terminal of the current sink transistor; and a second output transistor having current terminals coupled between the differential amplifier and the second supply voltage and having a control terminal coupled to the control terminal of the second input transistor; wherein the sink current booster is configured to mirror sink current through the current sink transistor to adjust the current of the differential amplifier.

In some embodiments, the integrated circuit further comprises a preset load coupled to the I/O reference node and the differential amplifier and having an enable input; and wherein the preset load is configured to adjust the current of the differential amplifier to enable faster load transient response of the unity gain buffer when the preset load is enabled.

In some embodiments, the I/O pad comprises one of a plurality of I/O pads, wherein the unity gain buffer comprises one of a plurality unity gain buffers each provided for a corresponding one of the plurality of I/O pads, wherein the I/O reference node comprises one of a plurality of I/O reference nodes, and wherein each of the plurality unity gain buffers has an input coupled to the input reference node and an output coupled to a corresponding one of the plurality of I/O reference nodes.

A unity gain buffer including a differential amplifier, detector and feedback circuitry, and an output stage. The differential amplifier receives a difference voltage between a buffer input and output, is coupled to a control node for modulating a current of the differential amplifier, and drives an output node. The detector and feedback circuitry has an input coupled to the buffer input and output and has an output coupled to the control node. The output stage has an input coupled to the output drive node and has an output coupled to the buffer output node. The differential amplifier draws minimal current when the difference voltage is substantially zero and increases current when the difference voltage increases causing the output stage to drive a voltage of the buffer output node back to a voltage of the buffer input node. At least one current booster or a preset load may be added.

Although the present invention has been described in connection with several embodiments, the invention is not intended to be limited to the specific forms set forth herein. On the contrary, it is intended to cover such alternatives, modifications, and equivalents as can be reasonably included within the scope of the invention as defined by the appended claims. For example, variations of positive circuitry or negative circuitry may be used in various embodiments in which the present invention is not limited to specific circuitry polarities, device types or voltage or error levels or the like. For example, circuitry states, such as circuitry low and circuitry high may be reversed depending upon whether the pin or signal is implemented in positive or negative circuitry or the like. In some cases, the circuitry state may be programmable in which the circuitry state may be reversed for a given circuitry function.

The terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles. Unless stated otherwise, terms such as "first" and "second" are used to arbitrarily distinguish between the elements such terms describe. Thus, these terms are not necessarily intended to indicate temporal or other prioritization of such elements.

## Claims

1. A unity gain buffer, comprising:
a buffer input node and a buffer output node developing a difference voltage;
a differential amplifier having a differential input coupled to receive the difference voltage, having a control input coupled to a control node for modulating current of the differential amplifier, and having an output coupled to an output drive node;
detector and feedback circuitry having a first input coupled to the buffer input node, having a second input coupled to the buffer output node, and having an output coupled to the control node; and
an output stage having an input coupled to the output drive node and having an output coupled to the buffer output node;
wherein the differential amplifier is configured to draw minimal current when the difference voltage is substantially zero and wherein the detector and feedback circuitry is configured to increase the current of the differential amplifier in response to an increase of a magnitude of the difference voltage causing the output stage to drive a voltage of the buffer output node towards a voltage of the buffer input node.

2. The unity gain buffer of claim 1, further comprising a current booster configured to sense source current through the output stage and to correspondingly adjust the current of the differential amplifier.

3. The unity gain buffer of claim 1 or 2,
wherein the differential amplifier comprises:
a differential transistor pair having a current tail node, having a first input coupled to the buffer input node, having a second input coupled to the buffer output node, having a first output, and having a second output coupled to output drive node;
an output current mirror referenced to a supply voltage, having an input coupled to the first output of the differential transistor pair and having an output coupled to the output drive node; and
a variable current source coupled between the current tail node and a supply reference voltage and having a control terminal coupled to the control node, wherein the variable current source is configured to develop a tail current between the current tail node and the supply reference voltage; and
wherein the output stage comprises a source follower stage, which comprises:
a current source transistor having current terminals coupled between a source node and the buffer output node and having a control terminal coupled to the output drive node; and
a current sink transistor having current terminals coupled between the buffer output node and a sink node and having a control terminal coupled to the output drive node.

4. The unity gain buffer of claim 3, wherein the unity gain buffer further comprises:
a source current booster, comprising:
a first input transistor having current terminals coupled between the supply voltage and the source node and having a control terminal coupled to the source node; and
a first output transistor having current terminals coupled between the supply voltage and the detector and feedback circuitry and having a control terminal coupled to the source node;
wherein the source current booster is configured to sense source current through the current source transistor and to correspondingly adjust the tail current through the variable current source.

5. The unity gain buffer of claim 3 or 4, wherein the unity gain buffer further comprises:
a sink current booster, comprising:
a second input transistor having current terminals interposed between the second supply voltage and the first current terminal of the current sink transistor and having a control terminal coupled to the first current terminal of the current sink transistor; and
a second output transistor having current terminals coupled between the current tail node and the supply reference voltage and having a control terminal coupled to the sink node;
wherein the sink current booster is configured to mirror sink current through the current sink transistor to an additional tail current between the current tail node and the supply reference voltage.

6. The unity gain buffer of any preceding claim, further comprising:
a preset load coupled to the buffer output node and the differential amplifier and having an enable input; and
wherein the preset load is configured to adjust the current of the differential amplifier to enable faster load transient response of the unity gain buffer when the preset load is enabled.

7. The unity gain buffer of any preceding claim, further comprising:
a preset load, comprising:
a plurality of cascaded transistors and an enable transistor each having current terminals coupled in series between the buffer output node and the supply reference voltage; and
a current transistor having current terminals coupled between a current node of the differential amplifier and the supply reference voltage and coupled in a mirrored configuration with a selected one of the plurality of cascaded transistors;
wherein when the enable transistor is enabled, the preset load is configured to adjust the current of the differential amplifier to enable faster load transient response of the unity gain buffer.

8. The unity gain buffer of any preceding claim, further comprising a first capacitive device coupled between a supply voltage and the output drive node and comprising a second capacitive device coupled between the output drive node and a supply reference voltage.

9. The unity gain buffer of any preceding claim, wherein the differential amplifier comprises:
a differential transistor pair comprising:
a first transistor of a first conductivity type having current terminals coupled between a first node and a current tail node and having a control terminal coupled to the buffer input node; and
a second transistor of the first conductivity type having current terminals coupled between the output drive node and the current tail node and having a control terminal coupled to the buffer output node;
an output current mirror comprising:
a first transistor of a second conductivity type having a first current terminal coupled to the supply voltage, and having a second current terminal and a control terminal coupled to the first node; and
a second transistor of the second conductivity type having current terminals coupled between the supply voltage and the output drive node and having a control terminal coupled to the first node; and
a variable current source coupled between the current tail node and the supply reference voltage and having a control terminal coupled to the control node.

10. The unity gain buffer of claim 9, wherein the output stage comprises:
a current source transistor of the first conductivity type having current terminals coupled between the supply voltage and the buffer output node and having a control terminal coupled to the output drive node; and
a current sink transistor of the second conductivity type having current terminals coupled between the buffer output node and the supply reference voltage and having a control terminal coupled to the output drive node.

11. The unity gain buffer of claim 10 or 11, wherein the detector and feedback circuitry comprises:
a first detector transistor of the second conductivity type having current terminals coupled between the buffer output node and the tail current control node and having a control terminal coupled to the buffer input node, and a second detector transistor of the first conductivity type having current terminals coupled between a mirror node and the buffer output node and having a control terminal coupled to the buffer input node;
a detector current mirror referenced to the supply voltage having an input coupled to the mirror node and having an output coupled to the tail current control node; and
a feedback current mirror including the variable current source and referenced to the supply reference voltage having an input coupled to the tail current control node and having an output coupled to the current tail node.

12. The unity gain buffer of claim 11, wherein the detector current mirror comprises:
a third transistor of the second conductivity type having a first current terminal coupled to the supply voltage and having a second current terminal and a control terminal coupled to the mirror node;
a fourth transistor of the second conductivity type having current terminals coupled between the supply voltage and a first node and having a control terminal coupled to the mirror node; and
a fifth transistor of the second conductivity type having current terminals coupled between the first node and the tail current control node and having a control terminal coupled to the buffer input node.

13. The unity gain buffer of claim 12, wherein the feedback current mirror comprises:
a third transistor of the first conductivity type having a first current terminal coupled to the supply reference voltage and having a second current terminal and a control terminal coupled to the control node; and
the variable current source comprising a fourth transistor of the first conductivity type having current terminals coupled between the current tail node and the supply reference voltage and having a control terminal coupled to the control node.

14. An integrated circuit, comprising:
an input reference node that develops a reference voltage relative to first and second supply voltages; and
an input/output (I/O) pad, comprising the unity gain buffer of any preceding claim;
wherein the buffer input node is coupled to the input reference node and the buffer output node is coupled to an I/O reference node;
wherein the differential amplifier is configured to draw minimal current when the difference voltage is substantially zero and wherein the detector and feedback circuitry is configured to increase the current of the differential amplifier in response to an increase of a magnitude of the difference voltage causing the output stage to drive a voltage of the I/O reference node towards a voltage of the input reference node.

15. The integrated circuit of claim 14, wherein the I/O pad further comprises:
a first pre driver having an input terminal coupled to a data output node, having an output coupled to a first gate node, having a first supply input coupled to the first supply voltage, and having a second supply input coupled to the I/O reference node;
a second pre driver having an input terminal coupled to the data output node, having an output coupled to a second gate node, having a first supply input coupled to the I/O reference node, and having a second supply input coupled to the second supply voltage;
a first plurality of cascaded driver devices coupled in series, each having current terminals coupled between the first supply voltage and an I/O pad output node and each having a control terminal coupled to the I/O reference node except a first driver device of the first plurality of cascaded driver devices which has a control terminal coupled to the first gate node; and
a second plurality of cascaded driver devices coupled in series, each having current terminals coupled between the second supply voltage and the I/O pad output node and each having a control terminal coupled to the I/O reference node except a first driver device of the second plurality of cascaded driver devices which has a control terminal coupled to the second gate node.
